# EUROPEAN PATENT APPLICATION

(11) **EP 4 521 473 A1**
(43) Date of publication of application: **12.03.2025**
(21) Application number: 22940782.0
(22) Date of filing: 23.12.2022
(51) Int. Cl.: H01L 31/18, H01L 31/068

(54) **SOLAR CELL AND PREPARATION METHOD THEREFOR, AND PHOTOVOLTAIC SYSTEM**

(30) Priority: 05.05.2022 CN 202210479616
(71) Applicant: Tongwei Solar (Chengdu) Co., Ltd., Chengdu, Sichuan 610299 (CN)
(72) Inventor: FAN, Jianbin, Meishan, Sichuan 620041 (CN); MENG, Xiajie, Meishan, Sichuan 620041 (CN); XING, Guoqiang, Meishan, Sichuan 620041 (CN)
(74) Representative: Michalski Hüttermann & Partner Patentanwälte mbB
(86) International application number: PCT/CN2022/141320
(87) International publication number: WO 2023/213088

(57) **Abstract**

The present disclosure relates to a preparation method for a solar cell, including: providing a silicon substrate having a first surface and a second surface opposite to the first surface; sequentially depositing an oxide layer, a doped amorphous silicon layer and a silicon oxide mask layer on the first surface of the silicon substrate; annealing the silicon substrate to transform the doped amorphous silicon layer into a doped polysilicon layer; patterning the first surface using a laser to destroy or remove the silicon oxide mask layer and the doped polysilicon layer in a preset region and retaining the entire or part of the oxide layer to form a patterned region. According to the preparation method, when texturing is performed on the front side of the silicon substrate, the first surface corresponding to the patterned region on the back side of the silicon substrate can be effectively prevented from being texturized, thereby improving the open-circuit voltage and the cell efficiency of the solar cell. Moreover, the present disclosure relates to a corresponding solar cell and a photovoltaic system.

## Description

### CROSS-REFERENCE TO RELATED APPLICATIONS

This application claims priority to Chinese Patent Application No. 2022104796166, filed to the Chinese Patent Office on May 5, 2022 and entitled "SOLAR CELL AND PREPARATION METHOD THEREFOR, AND PHOTOVOLTAIC SYSTEM", the entire contents of which are incorporated herein by reference.

### TECHNICAL FIELD

The present application relates to the technical field of solar cell production, and in particular to a solar cell and a preparation method therefor, and a photovoltaic system.

### BACKGROUND

In back contact cells, interdigitated back contact solar cells are known as IBC cells, the most distinctive feature of which is that the PN junction region or quasi-PN junction region, as well as the metal electrodes, are all located on the back side of the cell, without metal electrodes shading the front side of the cell.

Due to the above structural features, the IBC cell has a higher short-circuit current Jsc, and its back side can accommodate a wider metal grid line to reduce the series resistance Rs, thereby increasing the fill factor FF. In addition, this type of cell with no shading on the front side has high conversion efficiency and is more aesthetically pleasing. Therefore, IBC cells have become one of the technical directions for realizing high-efficiency crystalline silicon cells at present.

During the texturing process for preparing the back contact cell, it is required to simultaneously realize texturing on the front side of the silicon substrate and etching of the patterned region on the back side of the silicon substrate. In the back side region of the silicon substrate corresponding to the patterned region, it is only required to remove the tunneling oxide layer and the doped amorphous silicon layer by using a texturing solution during texturing, and there is no need to texture the silicon substrate in this region.

However, in the current texturing process, while the front side of the silicon substrate is being textured, the back side region of the silicon substrate corresponding to the patterned region is also textured, forming a textured structure on the back side of the silicon substrate, which greatly increases the metallization compound of this back side region, thereby reducing the open-circuit voltage and conversion efficiency of the cell.

### SUMMARY

In view of this, it is necessary to provide a solar cell, a preparation method therefor, and a photovoltaic system that can effectively prevent the back side region of the silicon substrate corresponding to the patterned region from being textured when the front side of the silicon substrate is textured.

The technical solution proposed in the present disclosure is as follows.

According to an aspect of the present disclosure, a preparation method for a solar cell is provided. The method includes:
providing a silicon substrate having a first surface and a second surface opposite to the first surface;
sequentially depositing an oxide layer, a doped amorphous silicon layer, and a silicon oxide mask layer on the first surface of the silicon substrate;
annealing the silicon substrate to transform the doped amorphous silicon layer into a doped polysilicon layer; and
patterning the first surface using a laser to destroy or remove the silicon oxide mask layer and the doped polysilicon layer in a preset region and retain all or part of the oxide layer, thereby forming a patterned region.

According to the present disclosure, after annealing the doped amorphous silicon layer to form the doped polysilicon layer, the first surface is patterned with the laser to destroy or remove the silicon oxide mask layer and the doped polysilicon layer in the predetermined region on the first surface to form the patterned region. The doped polysilicon layer formed after annealing has a shallow absorption depth for laser, so when patterning is performed using the laser, the interaction between the laser and silicon is limited to the doped polysilicon layer above the oxide layer, and the oxide layer will not be significantly damaged.

In the same alkaline solution, the silicon oxide (oxide layer 21) reacts slower than silicon, in other words, when texturing has begun on the front side of the solar cell, on the back side of the solar cell, the alkaline solution first reacts with the oxide layer and then reacts with the first surface of the silicon substrate. Through the interaction between the doped polysilicon layer and the laser, the oxide layer can be preserved without significant damage after patterning, so that the oxide layer can be used to extend the time duration in which the front side of the cell is being textured and the back side is not being textured. As a result, the front side is well texturized while only the oxide layer is removed from the patterned region on the back side, or the oxide layer is removed from the patterned region and the first surface is only "lightly textured" while the macroscopic appearance is still flat with high reflectivity, thereby ensuring that the solar cell has a higher open-circuit voltage and conversion efficiency.

In some embodiments, the laser is a picosecond pulse laser. The doped polysilicon layer formed after annealing has a shallow absorption depth for the picosecond pulse laser. During patterning, it can ensure that the interaction between the picosecond pulse laser and silicon is limited to the doped polysilicon layer above the oxide layer, thereby better protecting the oxide layer from significant damage.

In some embodiments, a wavelength of the picosecond pulse laser is 355nm or 532nm.

In some embodiments, a pulse width of the picosecond pulse laser ranges from 1ps to100ps.

In some embodiments, the silicon oxide mask layer is formed by vapor deposition, or thermal oxidation and annealing.

In some embodiments, an annealing temperature is 800°C to 950°C.

In some embodiments, the annealing time is 30 minutes to 50 minutes. Under the process conditions of such annealing temperature and annealing time, the doped amorphous silicon layer can be fully crystallized and fully transformed into the doped polysilicon layer, and the silicon oxide mask layer becomes denser, such that the PN junction region (the oxide layer, the doped amorphous silicon layer, etc.) on the first surface is less prone to be corroded by the alkaline texturing solution in the subsequent texturing process.

In some embodiments, the oxide layer is a silicon oxide layer, and a thickness of the oxide layer ranges from 0.5nm to 2.5nm.

In some embodiments, a thickness of the silicon oxide mask layer ranges from 10nm to 100nm.

In some embodiments, a thickness of the doped amorphous silicon layer ranges from 30nm to 300nm.

In some embodiments, after the patterned region is formed, the preparation method further comprises: immersing the silicon substrate in a texturing solution to remove the oxide layer in the patterned region and the remaining silicon oxide mask layer and the doped polysilicon layer in the patterned region, and to form a textured surface on the second surface.

In this way, the second surface of the silicon substrate can be textured to form a textured surface, and the patterned region on the first surface can be etched at the same time to effectively remove the oxide layer and the doped polysilicon layer in the patterned region, thereby exposing the first surface corresponding to the patterned region or the exposed first surface being only "lightly textured", i.e., it is in the initial stage of texturing and maintains a macroscopically flat appearance with a high reflectivity, which will not significantly impact the passivation and metallization compound. The remaining regions on the back side of the solar cell will not be corroded and damaged by the texturing solution due to the protection of the silicon oxide mask layer.

In some embodiments, the texturing solution is an alkaline solution containing a texturing additive.

In some embodiments, the immersing is carried out at a temperature of 30°C to 80°C.

In some embodiments, an immersing time is 300 seconds to 600 seconds. Under the process conditions of the above-mentioned texturing solution, immersion temperature and immersion time, the second surface of the silicon substrate can be fully texturized to form a velvet surface, and the oxide layer and doped polysilicon layer in the patterned area can be effectively removed to expose the corresponding first surface without causing velvet to form on the exposed first surface.

In some embodiments, after the immersion treatment, the preparation method further includes: depositing passivation layers on the first surface and the second surface of the silicon substrate, respectively. The passivation can be achieved by setting the passivation layers.

In some embodiments, the passivation layer is an aluminum oxide layer, and a thickness of the passivation layer ranges from 2nm to 25nm.

In some embodiments, after depositing the passivation layers, the preparation method further includes: depositing anti-reflection layers on the passivation layers on the first surface and the second surface, respectively. The anti-reflection layers can be used to reduce the reflectivity of the solar cell.

In some embodiments, the anti-reflection layer is any one of a silicon nitride layer, a silicon oxynitride layer, a silicon oxide layer, or any combination thereof, and a thickness of the anti-reflection layer ranges from 50nm to 150nm.

In some embodiments, after depositing the anti-reflection layers, the preparation method further includes:
performing a patterned drilling on the patterned region on the first surface using a laser to form an opening to remove the passivation layer and the anti-reflection layer at the opening to form an electrode contact region; and
injecting an electrode paste into the electrode contact region and the doped polysilicon layer to form a first electrode and a second electrode, respectively.

According to another aspect of the present disclosure, a solar cell is provided. The solar cell is prepared by the above-mentioned preparation method provided in the present disclosure.

According to another aspect of the present disclosure, a photovoltaic system is provided. The photovoltaic system includes the above solar cell provided in the present disclosure.

According to the above preparation method, the annealing treatment is performed to the doped amorphous silicon layer on the first surface to transform the amorphous silicon in the doped amorphous silicon layer into polysilicon to form a doped polysilicon layer. A laser is used to pattern a predetermined region on the first surface to destroy or remove the silicon oxide mask layer and the doped polysilicon layer in the predetermined region and retain all or part of the oxide layer to form a patterned region. When the laser patterning is performed, all or part of the oxide layer is retained by limiting the interaction between the laser and silicon to only the doped polysilicon layer above the oxide layer. The oxide layer can block the alkali solution used in the subsequent texturing process, such that prolong the time difference from the start of texturing to the formation of the textured surface on the first surface corresponding to the patterned region. It can be achieved that the front side of the solar cell is well texturized, and although the thin oxide layer on the laser patterned region on the back side will be corroded, it can ensure that the portion corresponding to the patterned region on the back side of the solar cell will not be texturized, or will only be "lightly textured" while the macroscopic appearance is still flat with a high reflectivity, thereby ensuring that the solar cell has a relatively high open-circuit voltage and conversion efficiency.

In addition, a picosecond pulse laser is used to pattern the predetermined region of the first surface after annealing. The doped polysilicon layer formed after annealing has a shallow absorption depth for the picosecond pulse laser, which can ensure that the interaction between the laser and silicon is limited to the doped polysilicon layer above the oxide layer. The oxide layer is retained while the silicon oxide mask layer and the doped polysilicon layer in the patterned region are destroyed or removed.

### BRIEF DESCRIPTION OF THE DRAWINGS

In order to better describe and explain embodiments and/or examples of the present disclosure, reference may be made to one or more drawings. Additional details or examples for describing the drawings should not be considered to limit the scope of any of the disclosed application, the present described embodiments and/or examples, or the preferred modes of the application as presently understood.
FIG. 1 is a schematic diagram of a structure of a solar cell prepared according to an embodiment of the present application.
FIG. 2 is a bottom view of the solar cell shown in FIG1.
FIG. 3 is a schematic diagram of a structure of a silicon substrate.
FIG. 4 is a schematic diagram of a structure of the silicon substrate after annealing.
FIG. 5 is a schematic diagram of a structure after performing a patterning process on a first surface.
FIG. 6 is a bottom view of the first surface after the patterning process.
FIG. 7 is a schematic diagram of a structure after the silicon substrate is textured and a silicon oxide mask layer is removed;
FIG. 8 is a bottom view of a structure after a drilling operation is performed to the patterned region.

### Description of reference numerals:

10: silicon substrate; 11: first surface; 12: second surface; 21: oxide layer; 22: doped amorphous silicon layer; 23: silicon oxide mask layer; 30: doped polysilicon layer; 40: patterned region; 50: passivation layer; 60: anti-reflection layer; 70: electrode contact region; 80: first electrode; 90: second electrode; 100: back contact solar cell.

### DETAILED DESCRIPTION

To make the purposes, features, and advantages of the present disclosure more obvious and easy to understand, detailed explanations of specific embodiments of the present disclosure are provided below in conjunction with the accompanying drawings. Many specific details are described below to facilitate a full understanding of the present disclosure. However, the present disclosure can be implemented in many other ways different from those described here. Those skilled in the art can make similar improvements without departing from the essence of the present disclosure. Therefore, the present disclosure is not limited to the specific exemplary embodiments disclosed below.

In addition, the terms "first" and "second" are used merely for the purpose of description, and should not be construed as indicating or implying relative importance or implicitly indicating a quantity of indicated technical features. Therefore, features defined by "first" or "second" may explicitly or implicitly include at least one of such features. In description of this application, "multiple" means at least two, such as two and three unless it is specifically defined otherwise.

In the present disclosure, unless otherwise explicitly specified and limited, the terms such as "installed", "connected", "coupled", "fixed" and the like should be interpreted in a broad sense. For example, it may be a fixed connection, a detachable connection, or an integral connection. It may be a mechanical connection or an electrical connection. It may be a direct connection or an indirect connection through an intermedium. It may be an internal communication between two elements or an interaction relationship between two elements, unless otherwise explicitly specified. For those skilled in the art, the specific meanings of the above terms in the present disclosure can be understood based on specific circumstances.

Unless otherwise defined, all technical and scientific terms used herein have the same meaning as commonly understood by one of ordinary skill in the art to which the present disclosure belongs. The terms used herein in the description of the present disclosure are only for the purpose of describing specific embodiments and are not intended to limit the present disclosure. As used herein, the term "and/or" includes any and all combinations of one or more of the associated listed items.

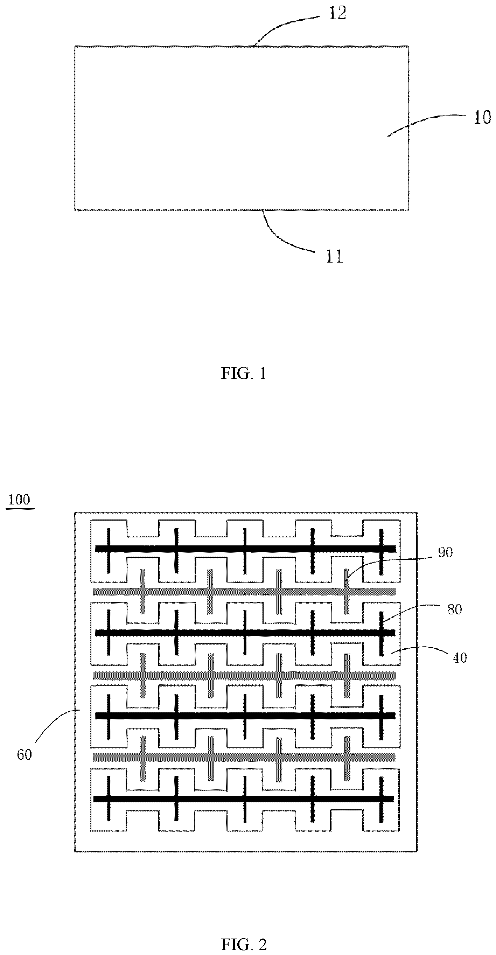

An embodiment of the present disclosure provides a preparation method for a back contact solar cell 100, and a structure of the back contact solar cell 100 is shown in FIG. 1 and FIG. 2. The preparation method includes the following steps S100 to S800.

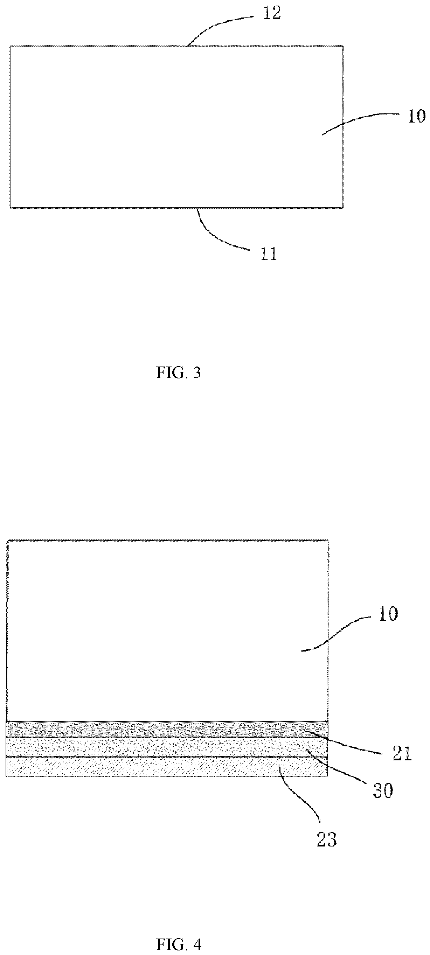

In step S100, a P-type silicon substrate 10 is provided. The silicon substrate 10 includes a first surface 11 and a second surface 12 opposite to the first surface 11. A structure of the silicon substrate 10 is shown in FIG. 3.

In some embodiments, a damage removal process, a polishing process, and a cleaning process are also performed on the silicon substrate 10 to make the surface of the silicon substrate 10 clean and smooth, thereby facilitating the subsequent coating process. The specific process is as follows: a damage removal process is performed on the surface of the silicon substrate 10 using a solution containing KOH at a temperature of about 60°C. Next, the silicon substrate 10 is polished using a solution containing KOH at a temperature of about 75°C so that the surface reflectivity of the polished silicon substrate 10 reaches 30%. Then, the polished silicon substrate 10 is cleaned using a mixed solution containing hydrofluoric acid and hydrochloric acid. Finally, the silicon substrate 10 is rinsed using deionized water and dried.

In step S200, an oxide layer 21, a doped amorphous silicon layer 22, and a silicon oxide mask layer 23 are sequentially deposited on the first surface 11 of the silicon substrate 10.

The oxide layer 21 is an ultra-thin silicon oxide layer directly disposed on the first surface 11. The thickness of the oxide layer 21 ranges from 0.5 nanometers (nm) to 2.5nm. The doped amorphous silicon layer 22 is a phosphorus-doped amorphous silicon layer. The thickness of the doped amorphous silicon layer 22 ranges from 30nm to 300nm, preferably 100nm to 150nm. The thickness of the silicon oxide mask layer 23 ranges from 10 nm to 100 nm, preferably 20nm to 50nm.

In some embodiments, the oxide layer 21, the doped amorphous silicon layer 22, and the silicon oxide mask layer 23 are prepared by the following method. First, the oxide layer 21 is formed on the first surface 11 of the silicon substrate 10 by chemical vapor deposition (such as Low Pressure Chemical Vapor Deposition (LPCVD), Plasma Enhanced Chemical Vapor Deposition (PECVD)), thermal oxidation, chain oxidation, etc. Next, the phosphorus-doped amorphous silicon layer 22 is formed on the surface of the oxide layer 21 away from the silicon substrate 10 by chemical vapor deposition (such as LPCVD, PECVD). Then, the silicon oxide mask layer 23 is formed on the surface of the doped amorphous silicon layer 22 away from the oxide layer 21 by PECVD, or thermal oxidation and annealing.

The oxide layer 21, the doped amorphous silicon layer 22, and the silicon substrate 10 form a PN junction together. The main function of the silicon oxide mask layer 23 is to protect the PN junction region (the oxide layer 21, the doped amorphous silicon layer 22, etc.) on the first surface 11 from being corroded by the alkaline texturing solution in the subsequent texturing process.

In step S300, an annealing process is performed on the silicon substrate 10 to transform the doped amorphous silicon layer 22 into a doped polysilicon layer 30. The structure of the silicon substrate 10 after annealing is shown in FIG. 4.

The annealing process can transform the amorphous silicon (a-Si) in the doped amorphous silicon layer 22 into polysilicon (poly) and cause the grains to grow to form the doped polysilicon layer 30.

In some embodiments, the annealing temperature is 800°C to 950°C, and the annealing time is 30 minutes to 50 minutes. Under such annealing process conditions, the doped amorphous silicon layer 22 can be fully crystallized and fully transformed into the doped polysilicon layer 30, and the silicon oxide mask layer 23 becomes denser, such that the PN junction region (the oxide layer 21, the doped amorphous silicon layer 22, etc.) on the first surface 11 is less prone to be corroded by the alkaline texturing solution in the subsequent texturing process.

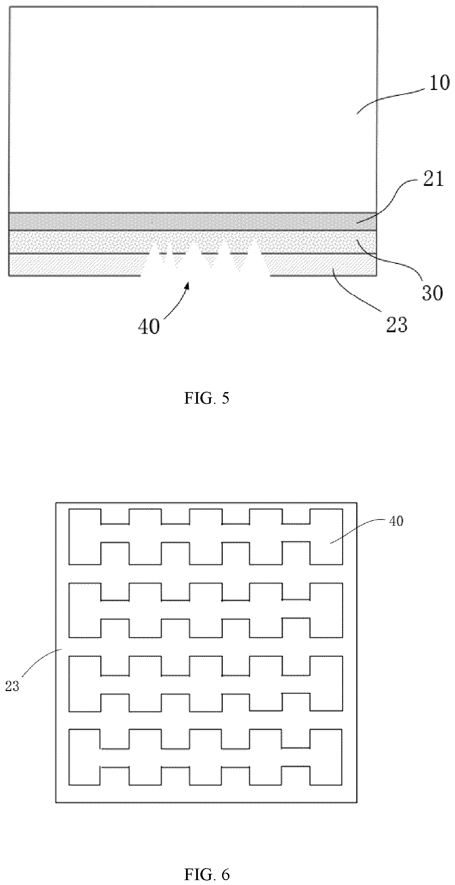

In step S400, the first surface 11 is patterned using a picosecond pulse laser to destroy or remove the silicon oxide mask layer 23 and the doped polysilicon layer 30 in a predetermined region while retaining the oxide layer 21, thereby forming a patterned region 40. The structure after patterning is shown in FIG. 5 and FIG. 6.

After annealing the doped amorphous silicon layer 22 on the first surface 11, in the present disclosure, the first surface 11 is patterned using the picosecond pulse laser to destroy or remove the silicon oxide mask layer 23 and the doped polysilicon layer 30 in the predetermined region on the first surface 11, thereby forming the patterned region 40. An electrode directly connected to the silicon substrate 10 can be prepared in the patterned region 40. The width of the patterned region 40 ranges from 300µm to 500µm.

When preparing the back-contact solar cell 100, it is required to simultaneously perform texturing on the front side of the cell and etching the patterned region 40 on the back side of the cell to expose the first surface 11 of the P-type silicon substrate 10. However, at present, the silicon oxide mask layer 23 is typically patterned using a laser. During the patterning process, the laser interacts with silicon, which easily causes damage to the oxide layer 21 within the patterned region 40. As a result, during the texturing process, while the front side is being textured, the patterned region 40 on the back side is also textured, so that a textured structure is also formed on the first surface 11 of the silicon substrate 10 corresponding to the patterned region 40, which greatly increases the metallization compound of the first surface 11 in this region, thereby reducing the open-circuit voltage and conversion efficiency of the cell. The ideal morphology of the region corresponding to the patterned region 40 on the first surface 11 after texturing is planar.

To solve the above problems, in the present disclosure, after annealing the doped amorphous silicon layer 22 to form the doped polysilicon layer 30, the first surface 11 is patterned with the picosecond pulse laser to destroy or remove the silicon oxide mask layer 23 and the doped polysilicon layer 30 in the predetermined region on the first surface 11 to form the patterned region 40. The doped polysilicon layer 30 formed after annealing has a shallow absorption depth for the picosecond pulse laser, so when the patterning process is performed using the picosecond pulse laser, the interaction between the laser and silicon is limited to the doped polysilicon layer 30 above the oxide layer 21, and the oxide layer 21 will not be significantly damaged.

In the same alkaline solution (such as texturing solution), the silicon oxide (oxide layer 21) reacts slower than silicon, in other words, when the texturing has begun on the front side of the solar cell, on the back side of the solar cell, the alkaline solution first reacts with the oxide layer 21 and then reacts with the first surface 11 of the silicon substrate 10. Through the interaction between the doped polysilicon layer 30 and the picosecond pulse laser, the oxide layer 21 can be preserved without significant damage after patterning, so that the oxide layer 21 can be used to extend the time duration in which the front side of the cell is being textured and the back side is not being textured. It is achieved that the front side is well texturized, while only the oxide layer 21 is removed from the patterned region 40 on the back side, or the oxide layer 21 is removed from the patterned region and the first surface 11 is only "lightly textured" with an etching depth less than 1µm, maintaining a macroscopically flat appearance with a relatively high reflectivity greater than 25%, thereby ensuring that the solar cell has a high open-circuit voltage and conversion efficiency.

In some embodiments of the present disclosure, the wavelength of the picosecond pulse laser is 355nm or 532 nm, and the pulse width of the picosecond pulse laser ranges from 1 picosecond (ps) to 100ps, preferably 3ps to 15ps. The patterning process can be achieved using a picosecond laser device, which utilizes the above picosecond pulse laser to remove the silicon oxide mask layer 23 on the partial region of the first surface 11.

By using the above patterning process, the region of the first surface 11 corresponding to the patterned region 40 has a polished morphology structure after the subsequent texturing process, which can effectively reduce the metallization compound of aluminum-silicon contact in this region compared to the case where the region of the first surface 11 corresponding to the patterned region 40 is textured, increasing the open-circuit voltage of the solar cell by 2mV to 5mV, thereby increasing the efficiency of the back-contact solar cell 100 by approximately 0.1% to 0.2%.

In step S500, first, the second surface 12 of the silicon substrate 10 is treated with a solution containing hydrofluoric acid or a mixture of hydrofluoric acid and concentrated nitric acid to remove the over-plating that may exist on the second surface 12, and then the silicon substrate 10 is immersed in a texturing solution to remove the oxide layer 21 in the patterned region 40 and the remaining silicon oxide mask layer 23 and doped polysilicon layer 30 in the patterned region 40 after the patterning process, and to form a textured surface on the second surface 12.

After patterning the predetermined region of the first surface 11 with the above picosecond pulse laser to form the patterned region 40, in the present disclosure, first, only the second surface 12 is treated using a solution containing hydrofluoric acid or a mixture of hydrofluoric acid and concentrated nitric acid to remove the over-plating that may exist on the second surface 12. Subsequently, the silicon substrate 10 is treated using the texturing solution to remove the oxide layer 21 in the patterned region 40 and the remaining silicon oxide mask layer 23 and the doped polysilicon layer 30 in the patterned region 40, and to form a textured surface on the second surface 12.

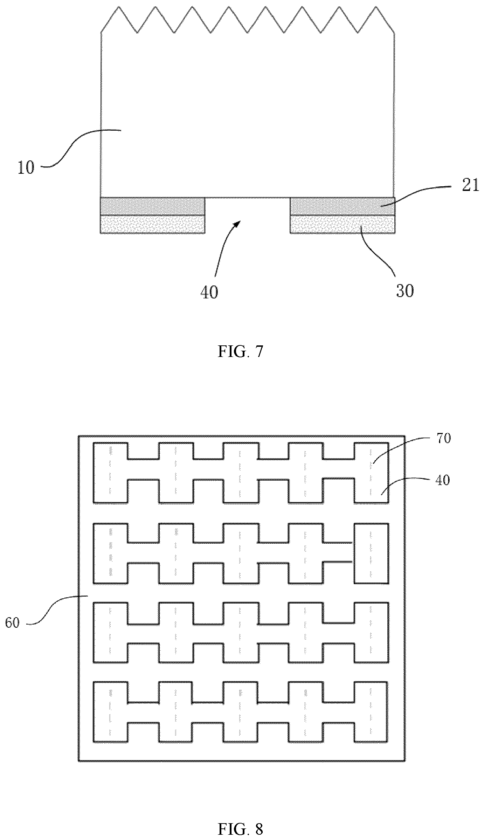

By using the above method, the second surface 12 (the front side) of the silicon substrate 10 can be textured to form a textured surface, and the patterned region 40 on the first surface 11 can be etched at the same time to effectively remove the oxide layer 21 and the doped polysilicon layer 30 in the patterned region 40, thereby exposing the first surface 11 corresponding to the patterned region 40 or the exposed first surface 11 being only "lightly textured", i.e., it is in the initial stage of texturing and maintains a macroscopically flat appearance with a relatively high reflectivity (over 25%), which will not significantly impact the passivation and metallization compound. The remaining regions of the back side of the solar cell will not be corroded and damaged by the texturing solution due to the protection of the silicon oxide mask layer 23. After the texturing process, conventional wet surface cleaning processes including water washing, alkali cleaning, water washing, acid cleaning, and water washing are sequentially performed, and finally a drying process is performed. The acid cleaning is performed by using an acid solution containing hydrofluoric acid to remove the silicon oxide mask layer 23. The structure after texturing and removing the silicon oxide mask layer 23 is shown in FIG. 7.

Texturing is a process of gradual reaction between the alkaline solution and silicon. In the initial stage of the reaction, the surface begins to be textured, which can be understood as a large number of pyramid spires are formed. In this stage, the depth of silicon etching is relatively shallow, on the order of hundreds of nanometers, and the macroscopic appearance still appears planar, i.e., the reflectivity is still high, generally over 25%. As the reaction progresses, due to the anisotropy of the reaction between the alkaline solution and silicon, the alkaline solution mainly corrodes along the <100> crystal plane, and finally a number of pyramidal structures are formed on the surface. At this time, the pyramid is relatively small, but the reflectivity has dropped significantly. As the reaction proceeds over time, the pyramid continues to grow, at this time, the pyramid height is about 1µm to 3µm, and the reflectivity is generally 9% to 11%.

In some embodiments, the texturing solution is an alkaline solution containing a texturing additive. The immersion treatment for texturing is carried out at a temperature of 30°C to 80°C, and the immersion treatment for texturing lasts for 300 seconds to 600 seconds. Under this process condition, the second surface 12 of the silicon substrate 10 can be fully textured to form a textured surface, and the oxide layer 21 and the doped polysilicon layer 30 in the patterned region 40 can be effectively removed to expose the corresponding first surface 11 without causing the exposed first surface 11 to be textured.

In step S600, passivation layers 50 are deposited on the first surface 11 and the second surface 12 of the silicon substrate, respectively, and then anti-reflection layers 60 are deposited on the passivation layers 50 on the first surface 11 and the second surface 11, respectively. By providing the passivation layers 50 and the anti-reflection layers 60, a passivation and a reduction in the reflectivity of the solar cell can be achieved, respectively.

In an embodiment, the passivation layer 50 is an aluminum oxide layer that is grown using an ALD (Atomic Layer Deposition) method. The thickness of the passivation layer 50 ranges from 2nm to 25nm. The anti-reflection layer 60 is any one of a silicon nitride layer, a silicon oxynitride layer, a silicon oxide layer, or any combination thereof. The thickness of the anti-reflection layer 60 ranges from 50nm to 150nm.

In step S700, a patterned drilling operation is performed to the patterned region 40 of the first surface 11 of the silicon substrate 10 using a laser to form an opening, so as to remove the passivation layer 50 and the anti-reflection layer 60 at the opening to form an electrode contact region 70, and then electrode paste is injected into the electrode contact region 70 and the doped polysilicon layer 30 outside the patterned region 40 to form a first electrode 80 and a second electrode 90, respectively. The structure after drilling the opening on the patterned region 40 is shown in FIG. 8.

**In** the drilling process, only partial contact portions under the fingers of the patterned region 40 need to be drilled, and the N-type region (the region outside the patterned region 40) does not need to be drilled, because the paste used for the first electrode 80 is typically a non-burn-through paste, i.e., it cannot burn through the passivation layer 50 and the anti-reflection layer 60 at high temperature, while the paste used in the N-type region is a burn-through paste, which can burn through the passivation layer 50 and the anti-reflection layer 60.

The first electrode 80 is directly connected to the silicon substrate 10, and the second electrode 90 is directly connected to the doped polysilicon layer 30 in the region outside the patterned region 40 on the first surface 11. In some embodiments, the first electrode 80 is an aluminum grid electrode. The width of the first electrode 80 ranges from 50µm to 200µm. The second electrode 90 is a silver grid electrode. The width of the second electrode 90 ranges from 10µm to 50µm.

Specifically, when performing the patterned drilling on the patterned region 40 using the laser, the openings are distributed in a dotted line or dot shape. The width of the opening ranges from 30µm to 50µm, that is, the width of the electrode contact region 70 ranges from 30µm to 50µm. Electrode paste layers containing conductive composition can be formed in the electrode contact region 70 and the region outside the patterned region 40 by screen printing to serve as the first electrode 80 and the second electrode 90, respectively.

The structure of the back contact solar cell 100 provided in the present disclosure is shown in FIG. 1 and FIG. 2. The back contact solar cell 100 can be used as a cell unit in various photovoltaic systems. Compared with the back contact solar cell 100 prepared by the traditional method, the open circuit voltage of the back contact solar cell 100 provided in the present disclosure can be increased by 2mV~5mV, and the cell efficiency of the back contact solar cell 100 can be increased by about 0.1%~0.2%.

The technical features in the foregoing embodiments may be randomly combined. For concise description, not all possible combinations of the technical features in the embodiments are described. However, provided that combinations of the technical features do not conflict with each other, the combinations of the technical features are considered as falling within the scope recorded in this specification.

The above-mentioned embodiments only illustrate several embodiments of the present disclosure, and the descriptions of which are relatively specific and detailed, but should not be construed as limitations to the scope of the present disclosure. It should be noted that, for those skilled in the art, variations and improvements can be made without departing from the concept of the present disclosure, which all belong to the protection scope of the present disclosure. Therefore, the protection scope of the present disclosure shall be subject to the appended claims, and the description and drawings can be used to interpret the contents of the claims.

## Claims

1. A preparation method for a solar cell, comprising:
providing a silicon substrate having a first surface and a second surface opposite to the first surface;
sequentially depositing an oxide layer, a doped amorphous silicon layer, and a silicon oxide mask layer on the first surface of the silicon substrate;
annealing the silicon substrate to transform the doped amorphous silicon layer into a doped polysilicon layer; and
patterning the first surface using a laser to destroy or remove the silicon oxide mask layer and the doped polysilicon layer in a preset region and retain all or part of the oxide layer, thereby forming a patterned region.

2. The preparation method for a solar cell according to claim 1, wherein the laser is a picosecond pulse laser.

3. The preparation method for a solar cell according to claim 2, wherein a wavelength of the picosecond pulse laser is 355nm or 532nm, and a pulse width of the picosecond pulse laser ranges from 1ps to 100ps.

4. The preparation method for a solar cell according to any one of claims 1 to 3, wherein the silicon oxide mask layer is formed by vapor deposition, or thermal oxidation and annealing.

5. The preparation method for a solar cell according to any one of claims 1 to 4, wherein an annealing temperature is 800°C to 950°C.

6. The preparation method for a solar cell according to any one of claims 1 to 5, wherein an annealing time is 30 minutes to 50 minutes.

7. The preparation method for a solar cell according to any one of claims 1 to 6, wherein the oxide layer is a silicon oxide layer, and a thickness of the silicon oxide layer ranges from 0.5nm to 2.5nm.

8. The preparation method for a solar cell according to any one of claims 1 to 7, wherein a thickness of the silicon oxide mask layer ranges from 10nm to 100nm.

9. The preparation method for a solar cell according to any one of claims 1 to 8, wherein a thickness of the doped amorphous silicon layer ranges from 30nm to 300nm.

10. The preparation method for a solar cell according to any one of claims 1 to 9, wherein after the patterned region is formed, the method further comprises:
immersing the silicon substrate in a texturing solution to remove the oxide layer in the patterned region and the remaining silicon oxide mask layer and the doped polysilicon layer in the patterned region, and to form a textured surface on the second surface.

11. The preparation method for a solar cell according to claim 10, wherein the texturing solution is an alkaline solution containing a texturing additive.

12. The preparation method for a solar cell according to claim 10 or 11, wherein the immersing is carried out at a temperature of 30°C to 80°C.

13. The preparation method for a solar cell according to any one of claims 10 to 12, wherein an immersing time is 300 seconds to 600 seconds.

14. The preparation method for a solar cell according to any one of claims 10 to 13, wherein after the immersing, the method further comprises:
depositing passivation layers on the first surface and the second surface of the silicon substrate, respectively.

15. The preparation method for a solar cell according to claim 14, wherein the passivation layer is an aluminum oxide layer, and a thickness of the passivation layer ranges from 2nm to 25nm.

16. The preparation method for a solar cell according to claim 14 or 15, wherein after depositing the passivation layers, the method further comprises:
depositing anti-reflection layers on the passivation layers on the first surface and the second surface, respectively.

17. The preparation method for a solar cell according to claim 16, wherein the anti-reflection layer is any one of a silicon nitride layer, a silicon oxynitride layer, a silicon oxide layer, or a combination thereof, and a thickness of the anti-reflection layer ranges from 50nm to 150nm.

18. The preparation method for a solar cell according to claim 16 or 17, wherein after depositing the anti-reflection layers, the method further comprises:
performing a patterned drilling on the patterned region on the first surface using a laser to form an opening, and removing the passivation layer and the anti-reflection layer at the opening to form an electrode contact region; and
injecting an electrode paste into the electrode contact region and the doped polysilicon layer to form a first electrode and a second electrode, respectively.

19. A solar cell, wherein the solar cell is prepared by the preparation method according to any one of claims 1 to 18.

20. A photovoltaic system, wherein the photovoltaic system comprises the solar cell according to claim 19.
